# FASCICULE DE BREVET EUROPEEN

(11) **EP 0 735 694 B1**
(45) Date de publication et mention de la délivrance du brevet: **01.08.2001**
(21) Numéro de dépôt: 96400563.1
(22) Date de dépôt: 18.03.1996
(51) Int. Cl.: H03M 3/00, H03M 3/02

(54) **Dispositif de faible coût et intégrable pour l'acquisition de signaux électriques selon la norme ARINC 429**
Kostengünstige integrierbare Vorrichtung zur Verarbeitung elektrischer Signale nach der ARINC-429-Norm
Low price device for the aquisition of electrical signals according to ARINC 429 standard

(30) Priorité: 27.03.1995 FR 9503659
(43) Date de publication de la demande: 02.10.1996
(73) Titulaire: SEXTANT AVIONIQUE, 78141 Velizy Villacoublay (FR)
(72) Inventeur: Pitot, Christian, 92100 Boulogne (FR); Vriz, Louis, 91140 Villebon sur Yvette (FR)
(74) Mandataire: de Saint-Palais, Arnaud Marie

(56) Documents cités:
- US-A- 4 298 959
- NUCLEAR INSTRUMENTS & METHODS IN PHYSICS RESEARCH, SECTION - A: ACCELERATORS, SPECTROMETERS, DETECTORS AND ASSOCIATED EQUIPMENT, vol. A307, no. 2/03, 1 Octobre 1991, pages 436-447, XP000264949 HALLGREN B: "POSSIBLE APPLICATIONS OF THE SIGMA DELTA DIGITIZER IN PARTICLE PHYSICS"

## Description

La présente invention concerne un dispositif pour l'acquisition et la conversion analogique/numérique de signaux électriques nécessitant une mise en forme analogique, notamment pour minimiser, voire supprimer les effets des perturbations radioélectriques.

Elle s'applique notamment, mais non exclusivement aux transmissions de données numériques selon la norme ARINC 429 qui est utilisée à bord des aérodynes.

La norme ARINC 429 définit un protocole de transmission de données numériques par une liaison filaire comprenant une paire de fils torsadés et blindés. Elle est essentiellement appliquée aux transmissions de données entre les différents équipements électroniques embarqués à bords des aérodynes, ces transmissions étant effectuées par modulation en tension différentielle entre un émetteur unique et une pluralité de destinataires.

Selon cette norme, une donnée numérique est transmise à une vitesse de 12,5 ou 100 kilobits par seconde, grâce à deux signaux analogiques H et L appliqués respectivement sur les deux fils de la liaison, ces deux signaux étant symétriques par rapport à une tension de référence voisine de zéro volts. Un bit à 1 est représenté par le signal H par un trapèze ayant une plage à tension constante voisine d'une tension maximum de +10 volts, suivi d'une plage à tension voisine de la tension de référence. D'une manière analogue, un bit à 0 est représenté par un trapèze ayant une plage à tension constante voisine d'une tension minimum de -10 volts, suivi d'une plage à tension voisine de la tension de référence.

Afin d'assurer la réception de tels signaux, on détecte dans ces signaux, les niveaux de tension maximum, minimum et de référence, pour engendrer deux signaux logiques correspondant respectivement aux signaux H et L reçus en entrée. A l'heure actuelle, pour effectuer la détection des différents niveaux, on utilise des comparateurs à seuils analogiques.

Or, on a pu observer une miniaturisation spectaculaire des appareils électroniques, et notamment ceux utilisés en avionique, grâce à l'application des techniques de l'électronique numérique. En contrepartie, ce phénomène n'a pas été aussi significatif pour l'électronique analogique. Il s'avère donc que les circuits de réception de données ARINC 429 sont difficiles à intégrer dans des composants de coût réduit et de faible encombrement.

Par ailleurs, étant donné qu'une ligne de transmission ARINC 429 ne peut comporter qu'un seul émetteur, certains appareils de conduite de vol comportent plusieurs dizaines de voies d'acquisition de signaux ARINC 429. Il en résulte que ces appareils présentent un coût très élevé et un encombrement qui peut difficilement être réduit par les techniques de l'électronique numérique.

Pour résoudre ce problème, on a tenté de regrouper les voies d'entrée en utilisant la technique du multiplexage. Il s'avère que dans cette solution, une voie d'entrée multiplexée peut être "éblouie" par une source qui occupe complètement la voie et, de ce fait, empêche les autres sources de d'émettre. Cette solution est donc peu compatible avec les contraintes de sécurité et de fiabilité en vigueur dans l'aéronautique.

Par ailleurs, il existe des techniques d'intégration de circuits analogiques, comme les techniques monolithique ou hybride. Cependant les circuits intégrés monolithiques et hybrides, qui doivent être actifs pour pouvoir réaliser des comparateurs à seuils, demeurent coûteux et autorisent un niveau d'intégration relativement faible par rapport aux composants numériques. En outre, ces composants sont peu utilisés, et donc leur pérennité est loin d'être assurée.

On connaît également un convertisseur analogique numérique du type sigma-delta, par exemple du document "Possible applications of the sigma delta digitizers in particle physics" de B. Hallgren. Un tel convertisseur comprend :
- un condensateur qui est chargé par le signal analogique reçu,
- un comparateur à seuil pour comparer à un seuil la tension aux bornes du condensateur, et délivrer un signal logique dont l'état est fonction du résultat de la comparaison,
- une bascule connectée à la sortie du comparateur à seuil,
- des moyens de correction pour appliquer une correction de charge ou de décharge au condensateur, suivant l'état de la bascule, de manière à charger ou décharger le condensateur et ramener sa tension vers la tension de seuil, et
- un circuit de filtrage et de comptage comprenant des moyens pour compter, à l'aide du signal image de l'état de la bascule, parmi les N dernières corrections appliquées au condensateur, le nombre de corrections de décharge auquel est retranché le nombre de corrections de charge, le nombre ainsi obtenu étant à tout instant représentatif du signal analogique reçu.

Toutefois, ce convertisseur fait intervenir à la fois des composants analogiques et des composants numériques, de sorte qu'il est également difficile à intégrer dans des composants à coût réduit et de faible encombrement.

La présente invention a pour but de supprimer ces inconvénients. A cet effet, elle propose un dispositif pour la conversion d'un signal analogique de transmission de données numériques en un signal numérique, faisant intervenir un convertisseur de type sigma-delta.

Selon l'invention, ce dispositif est caractérisé en ce qu'il comprend :
- un circuit analogique purement passif auquel est appliqué le signal analogique reçu, qui comprend le condensateur, une borne de connexion, une première résistance au travers de laquelle le condensateur se charge par le signal analogique reçu, et une seconde résistance par l'intermédiaire de laquelle le condensateur est connecté à la borne de connexion, et
- un circuit numérique apte à fournir ledit signal numérique, connecté à la borne de connexion, et comprenant un circuit numérique de mesure et de correction et le circuit de filtrage et de comptage, le circuit numérique de mesure et de correction comportant le comparateur à seuil, la bascule, les moyens de correction et des moyens pour prélever, pendant une phase de mesure périodique, la tension à la borne de connexion et l'appliquer au comparateur à seuil dont la sortie est stockée dans la bascule, les moyens de correction comprenant des moyens pour appliquer à la borne de connexion, pendant une phase de correction périodique en alternance avec la phase de mesure, une tension de correction de charge ou de décharge du condensateur dans la seconde résistance.

Grâce à ces dispositions, le circuit analogique n'est constitué que de résistances et de condensateurs. Il est donc purement passif et peut de ce fait être intégré dans un composant passif de type hybride, tel qu'un réseau DIL, très bon marché et de faible encombrement. Par ailleurs, étant donné la simplicité du circuit analogique, on est assuré de la pérennité de tels circuits hybrides.
Par ailleurs, grâce au traitement effectué sur le signal en aval du comparateur à seuil, il n'est pas nécessaire d'employer un comparateur de grande précision, ce qui permet de remplacer les comparateurs analogiques normalement utilisés par un seul comparateur numérique, le circuit de filtrage et de comptage permettant de s'affranchir d'éventuelles dérives au niveau du seuil.
On obtient ainsi un dispositif parfaitement adapté à la réception de signaux analogiques de transmission de données numériques.

Avantageusement, les bornes de sortie du circuit analogique sont disposées de manière à réduire au maximum la longueur des liaisons entre les circuits analogique et numérique. De cette manière, on réduit au maximum la valeur des capacités parasites dues aux connexions et aux liaisons.

Selon une particularité de l'invention, le dispositif permet d'effectuer l'acquisition de signaux différentiels transmis respectivement par deux voies différentielles. Pour cela il comprend :
- un circuit analogique comprenant deux voies comportant chacune le condensateur et les premières et seconde résistance, sur lesquelles sont appliqués respectivement les deux signaux différentiels, et
- deux circuits identiques audit circuit numérique connectés respectivement aux sorties des voies du circuit analogique,
- des comparateurs numériques aptes à détecter différents niveaux de tension, à l'aide des valeurs numériques représentatives des signaux analogiques différentiels d'entrée, et
- un circuit logique conçu pour engendrer un signal logique représentatif du signal d'entrée à partir des signaux issus desdits comparateurs numériques.

Avantageusement, le dispositif pour l'acquisition de signaux différentiels comprend un seul circuit de filtrage et de comptage connecté aux deux circuits de mesure et de correction par l'intermédiaire d'un circuit d'interface réalisant la fonction suivante :
- si les sorties des circuits de mesure et de correction sont identiques à un instant donné, le circuit d'interface applique au circuit de filtrage et de comptage une valeur fixée arbitrairement et alternativement aux deux valeurs de tension de correction, et
- si les sorties des circuits de mesure et de correction sont opposées, le circuit d'interface applique au circuit de filtrage et de comptage la valeur de la correction appliquée à l'une des deux voies différentielles.

Un mode de réalisation du dispositif selon l'invention sera décrit ci-après, à titre d'exemple non limitatif, avec référence aux dessins annexés dans lesquels :
La figure 1 représente schématiquement le dispositif selon l'invention ;
La figure 2 illustre sous la forme d'un ensemble de chronogrammes le principe de fonctionnement du dispositif selon l'invention ;
La figure 3 représente schématiquement un circuit numérique de décimation adapté à l'acquisition du signal en sortie du circuit représenté sur la figure 1 ;
La figure 4 montre un dispositif adapté à l'acquisition d'un signal transmis sous la forme d'une paire différentielle, tel qu'un signal ARINC 429 ;
La figure 5 montre la forme d'un signal ARINC 429, et la forme des signaux obtenus en sortie du dispositif représenté sur la figure 4.

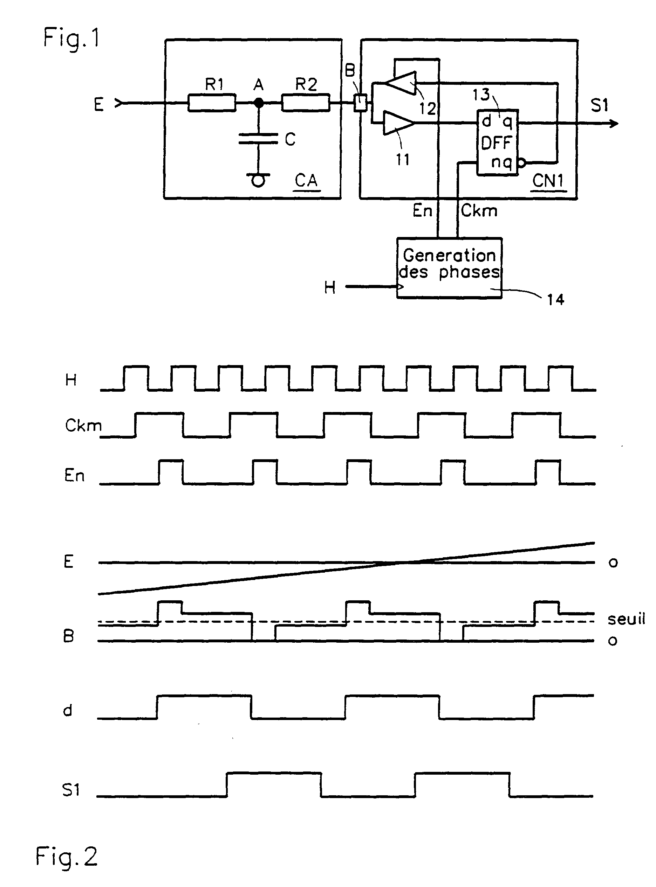

Le dispositif représenté sur la figure 1 comprend un circuit analogique CA connecté à un circuit numérique CN1. Le circuit analogique CA est constitué d'un pont à point de jonction A auquel est connecté :
- une résistance R1 par laquelle transite le signal à traiter E,
- un condensateur C relié à la masse, et
- une résistance R2 par laquelle passe le signal de sortie du circuit analogique CA qui est appliqué à la borne d'entrée B du circuit numérique CN1.

Le circuit numérique CN1 comprend un comparateur à seuil dont l'entrée est reliée à la borne d'entrée B et à la sortie d'une mémoire tampon 12. Ce circuit comprend également une bascule D 13 comprenant une entrée d sur laquelle est appliqué le signal délivré par le comparateur à seuil 11. Le signal émis sur la sortie q de la bascule 13 est envoyé en sortie SI du circuit numérique CN1, tandis que la sortie inversée ng de la bascule 13 est reliée à l'entrée de la mémoire tampon 12.

Le circuit numérique CN1 est cadencé par un générateur de phases 14 conçu pour fournir deux signaux carrés synchrones Ckm et En en fonction d'un signal d'horloge H appliqué à l'entrée du générateur 14, le signal Ckm étant appliqué à l'entrée du signal d'horloge de la bascule D 13, et le signal En à la mémoire tampon 12 pour en commander l'état bloqué ou débloqué et ainsi valider ou non la sortie.

Par ailleurs, le circuit numérique CN1 est réalisé en technologie CMOS de manière à présenter une impédance d'entrée élevée, lorsque la mémoire tampon 12 est à l'état bloqué, et à se comporter comme une source de tension lorsque celle-ci se trouve à l'état débloqué.

Ainsi, sur la figure 2 qui montre les chronogrammes des signaux transitant en différents points du circuit de la figure 1, les signaux Ckm et En ont une fréquence égale à la moitié de celle du signal d'horloge H, le signal En présentant des flancs descendants en phase avec ceux du signal Ckm, et des flancs montants retardés d'un quart de période par rapport à ceux du signal Ckm.

La figure 2 montre également la forme des signaux en entrée B et en sortie SI du circuit numérique CN1, et en entrée d de la bascule D 13, en fonction d'un signal E appliqué en entrée du circuit analogique CA.

Le chronogramme du signal en B fait apparaître une succession de deux phases qui s'enchaînent indéfiniment à cadence fixe, à savoir :
- une phase de mesure durant laquelle l'entrée B du circuit numérique est en haute impédance, la mémoire tampon 12 étant à l'état bloqué, et durant laquelle le comparateur 11 détermine si la tension aux bornes du condensateur C est inférieure ou supérieure au seuil, par exemple égal à +2,5 volts, le résultat de la comparaison étant stocké dans la bascule D 13, et
- une phase de correction décomposable en deux sous phases de durée à priori voisines ; la première sous phase correspondant à la partie non active de la correction, au cours de laquelle la bascule peut se trouver dans un état métastable avant de se stabiliser pour appliquer un signal sur ses sorties directe q et inversée nq, le signal en sortie nq étant appliqué à la mémoire tampon 12 toujours en haute impédance ; durant la seconde sous phase, dite de correction active, la mémoire tampon 12 est débloquée grâce au signal En qui passe au niveau logique 1 (par exemple, + 5 volts), pour présenter une basse impédance, et contribuer à ramener la tension aux bornes du condensateur à l'opposé de la mesure précédente par rapport au seuil.

La forme du signal d montrée sur cette figure est obtenue grâce au comparateur 11 qui délivre un signal à 0 volts durant les périodes où le signal en B est en dessous du seuil, et un signal, par exemple, à + 5 volts durant les périodes où la tension en B est supérieure au seuil.
La valeur du signal en sortie q (= S1) de la bascule D 13, est mise à jour à chaque flanc montant du signal Ckm à la valeur du signal en entrée d, et la mémoire tampon 12 est chargée avec 0 volt si le signal en sortie S1 vaut 5 volts et inversement, avec 5 volts si le signal en sortie SI vaut 0 volts.

De cette manière, on assujettit le signal en B à rester voisin de la tension de seuil, le signal en sortie SI étant représentatif des corrections faites dans un sens ou dans l'autre et appliquées au condensateur C.
Si par la suite on utilise le signal SI pour réaliser une accumulation des corrections sur une durée fixe correspondant à N périodes de mesure, on peut évaluer la valeur de la tension d'entrée qui contribue également à faire évoluer la tension aux bornes du condensateur C à travers la résistance R1. On obtient ainsi un convertisseur analogique/numérique dont la précision dépend de la période d'accumulation des mesures, de la fréquence d'échantillonnage (Ckm) et bien évidemment, des limitations imposées par les caractéristiques analogiques des éléments mis en oeuvre par le dispositif selon l'invention. Il s'avère que la précision ainsi obtenue est largement suffisante pour l'acquisition de signaux ARINC 429.

Il est à noter que l'on utilise une seule broche B de connexion entre le circuit analogique CA et le circuit numérique CN1, cette broche étant utilisée à la fois dans la fonction de mesure et dans la fonction de correction qui prennent place dans le temps de façon exclusive. Cette répartition dans le temps des fonctions de mesure et de correction est obtenue grâce à la forme des signaux Ckm et En, et à leur synchronisme.

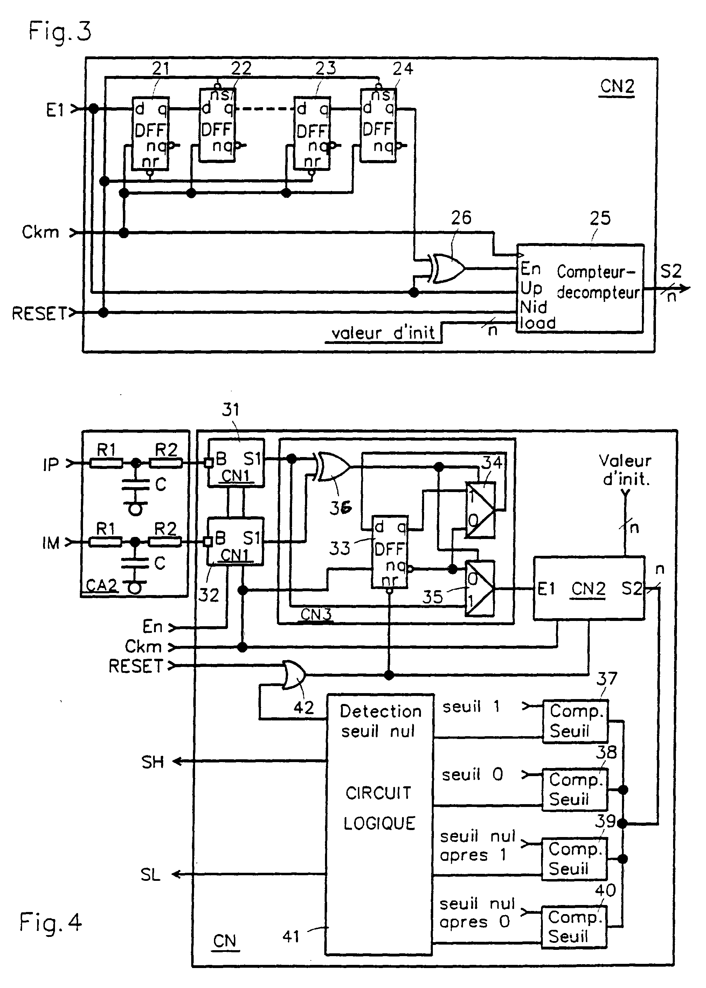

La figure 3 montre un circuit numérique CN2 de filtrage et de décimation permettant d'effectuer l'accumulation des corrections fournies par la sortie SI du circuit CN1 sur une période prédéterminée. Ce circuit CN2 comprend un registre à décalage constitué de N bascules D 21 à 24 montées en série et cadencées par le même signal Ckm, l'entrée d de la première bascule D 21 constituant l'entrée E1 de ce circuit CN2, et étant relié à la sortie SI du circuit CN1.

Ce circuit CN2 comprend également un compteur/décompteur 25 qui tient à jour un bilan des valeurs qui entrent et sortent du registre à décalage, de manière à contenir à tout instant, à une constante d'initialisation près le nombre de bits à 1 présents dans le registre à décalage, ce nombre étant représentatif de la tension moyenne du signal analogique appliqué en entrée E, sur une période correspondant aux N mesures précédentes, N étant le nombre de bascules 21 à 24 dans le registre à décalage.

Lors de l'initialisation du circuit CN2, on applique un signal RESET aux bascules D 21 à 24 du registre à décalage, alternativement, soit sur l'entrée de mise à 0, soit sur l'entrée de mise à 1 de manière à initialiser le registre à une valeur moyenne, par exemple 0 1 ... 0 1. Cette valeur moyenne qui correspond à la valeur d'initialisation, est également appliquée au compteur/décompteur 25.

A chaque flanc montant du signal Ckm, la valeur de correction issue du circuit CN1 est chargée dans la première bascule 21, tandis que les valeurs précédentes sont transmises de proche en proche dans les bascules D suivantes 22 à 24 par les sorties non inversées q, la valeur en sortie non inversée q de la dernière bascule D 24 étant appliquée à l'entrée d'une porte OU EXCLUSIF 26 dont l'autre entrée est reliée à l'entrée E1 du circuit CN2. Le compteur/décompteur 25 comprend en outre :
- une entrée Up reliée à l'entrée E1 du circuit CN2, et sur laquelle on présente la valeur à compter,
- une entrée En reliée à la sortie de la porte OU EXCLUSIF 26 permettant de déclencher le comptage de la valeur appliquée sur l'entrée Up, et
- une sortie parallèle reliée à la sortie S2 du circuit CN2, sur laquelle est appliquée la valeur du compteur/décompteur 25.

De cette manière, si le signal en entrée E1 est au niveau logique 0, la valeur du compteur/décompteur ne change pas. Par contre, si le signal en entrée E1 se trouve au niveau logique 1, la valeur du compteur/décompteur 25 est incrémentée, si le signal en sortie du registre à décalage est au niveau logique 0.
De même, la valeur du compteur/décompteur 25 est décrémentée, si le signal en entrée E1 est à 0 et si la sortie du registre à décalage est à 1.

Ainsi, le compteur/décompteur 25 n'est incrémenté que si une valeur à 1 remplace une valeur à 0 dans le registre à décalage, et décrémenté si une valeur à 0 remplace une valeur à 1 dans le registre à décalage.

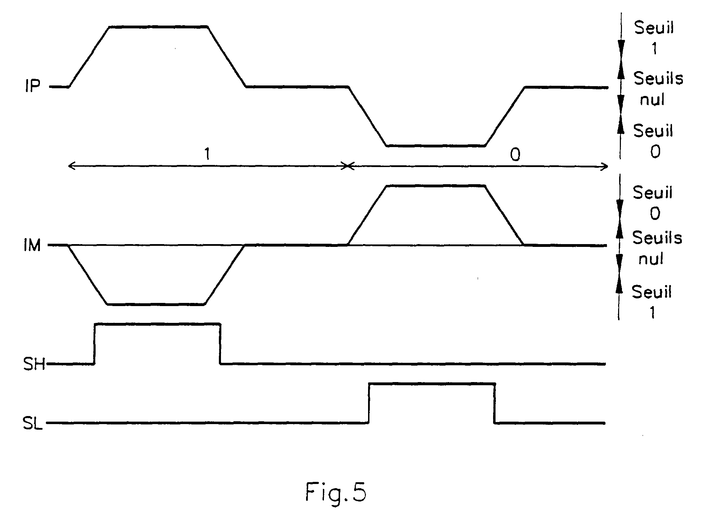

Le principe du dispositif décrit ci-avant peut avantageusement être appliqué à l'acquisition de signaux ARINC 429 dont la forme est illustrée sur la figure 5.
Un signal ARINC 429 comprend en fait deux signaux différentiels IP et IM, l'un étant à tout instant symétrique de l'autre par rapport à une tension de référence voisine de zéro. Selon la norme ARINC 429, une information binaire à 1 est représentée sur la voie positive IP par un signal trapézoïdal présentant une plage à tension constante positive de l'ordre de +10 volts, suivi d'un signal à tension constante voisine de la tension de référence, tandis qu'une information binaire à 0 est représentée par une phase à tension constante voisine de - 10 volts suivi d'un signal à tension voisine de la tension de référence.

Pour acquérir un tel signal, le dispositif représenté sur la figure 4 comprend deux voies d'entrée, à savoir une voie positive IP et une voie négative IM, correspondant au signal ARINC 429 transmis en différentiel sur deux lignes série. Ces deux entrées sont appliquées à un circuit analogique CA2 comprenant pour chacune des entrées, un pont comprenant les résistances R1 et R2 et le condensateur C, tels que décrits ci-avant.
Ce dispositif comprend également un circuit numérique CN comprenant deux circuits 31,32 du type du circuit CN1 décrit ci-avant et représenté sur la figure 1, les entrées B de ces deux circuits étant connectées aux sorties du circuit analogique CA2.

Avantageusement, ce dispositif ne comprend qu'un seul circuit de filtrage et de décimation CN2 pour deux voies d'acquisition analogiques. Pour cela, il comprend un circuit numérique CN3 comportant une porte OU EXCLUSIF 36 dont les entrées sont connectées aux sorties des circuits CN1 31 et 32. Ce circuit CN3 comprend également deux sélecteurs 34,35 comportant chacun une entrée de sélection reliée à la sortie de la porte OU EXCLUSIF 36, deux entrées référencées respectivement 0 et 1, et une sortie qui délivre le signal d'entrée 0 ou 1 sélectionné en fonction du niveau logique respectivement 0 ou 1, du signal de sélection appliqué sur l'entrée de sélection.

L'entrée 1 du premier sélecteur 34 est connectée à la sortie q d'une bascule D 33, tandis que l'entrée 0 de ce sélecteur est reliée à la sortie inversée nq de la bascule 33, et à l'entrée 0 de l'autre sélecteur 35. La sortie du premier sélecteur 34 est reliée à l'entrée d de la bascule 33, laquelle est cadencée par le signal Ckm produit par un générateur de phase tel que celui référencé 14 sur la figure 1. La sortie S1 du premier circuit CN1 31 est par ailleurs appliquée à l'entrée 1 du second sélecteur 35, dont la sortie est appliquée à l'entrée E1 du circuit CN2.

Le circuit CN3 réalise ainsi la fonction suivante :
- si les sorties des circuits CN1 sont identiques, c'est-à-dire, si les corrections appliquées aux deux entrées IP et IM sont identiques à un instant donné, on introduit dans le registre à décalage du circuit CN2 une valeur fixée arbitrairement et alternativement aux deux valeurs de correction possibles, soit 0 et + 5 volts, et
- si les corrections appliquées aux entrées IP et IM sont opposées, on introduit dans le registre à décalage du circuit CN2 la valeur de la correction appliquée à la voie positive IP.

Dans le dispositif représenté sur la figure 4, la sortie parallèle S2 du circuit CN2 est appliquée à quatre comparateurs numériques à seuils 37 à 40, de manière à pouvoir détecter le franchissement de quatre seuils représentés figure 5, c'est-à-dire, si les valeurs numériques émises par le circuit CN2 sont :
- supérieures au seuil du niveau logique 1 du signal ARINC 429,
- inférieures au seuil du niveau logique 0,
- inférieures au seuil du niveau de référence (voisin de 0 volts) après une détection du niveau 1, ou
- supérieures au seuil du niveau de référence après une détection du niveau 0.

Les sorties respectives des comparateurs à seuil 37 à 40 sont appliquées à l'entrée d'un circuit logique 41 conçu pour engendrer deux signaux logiques SH et SL montrés sur la figure 5, le signal SH contenant une impulsion pour représenter chaque information binaire à 1, et le signal SL une impulsion pour représenter chaque information binaire à 0, contenues dans les signaux IP et IM appliqués en entrée.

Par ailleurs, le circuit logique 41 comprend une sortie de détection de seuil nul, indiquant si le seuil de référence après un 1 ou après un 0 a été franchi, cette sortie étant reliée à l'entrée d'une porte OU 42 à laquelle est également appliqué le signal RESET d'initialisation. De cette manière, on provoque l'initialisation de la bascule D 33 et du circuit CN2, c'est-à-dire, du registre à décalage 21 à 24 et du compteur/décompteur 25 à une valeur moyenne, à chaque fois que le niveau de référence a été détecté dans les signaux d'entrée IP et IM.

A titre d'exemple, pour l'acquisition de signaux ARINC 429, la résistance R1 vaut 12 kΩ, la résistance R2 600 Ω, et le condensateur C 1,2 nF. Un signal ARINC étant transmis à la vitesse de 12,5 ou 100 kilobits/seconde, on utilise une horloge H de 20 MHz de manière à obtenir un suréchantillonnage du signal d'entrée.

Sur le schéma de la figure 4, la partie analogique est extrêmement réduite, et peut être facilement intégrée dans un circuit hybride de type réseau DIL. Par ailleurs, la partie numérique comprend uniquement des fonctions standard qui de ce fait peuvent facilement être intégrées dans un circuit numérique intégré. Il est souhaitable de disposer les broches de connexion B du circuit numérique CN en regard des broches de connexion du circuit analogique, de manière à supprimer les liaisons entre ces deux circuits et, ainsi, à réduire au maximum les capacités parasites résultant de ces liaisons.

Pour réaliser un dispositif permettant l'acquisition simultanée de plusieurs voies ARINC 429, on peut utiliser un seul générateur de phase pour l'ensemble des voies, à condition de cadencer les phases de mesure et de correction en opposition de phase pour des groupes de deux voies, de façon à répartir dans le temps les appels de courant fournis par l'alimentation du circuit, et ainsi, à en minimiser l'amplitude.

## Revendications

1. Dispositif pour la conversion d'un signal analogique de transmission de données numériques en un signal numérique, comprenant :
- un circuit analogique (CA) purement passif auquel est appliqué le signal analogique reçu, ce circuit comprenant un condensateur (C) qui est chargé par le signal analogique reçu, et une borne de connexion (B),
- un comparateur (11) à seuil pour comparer à un seuil la tension aux bornes du condensateur (C), et délivrer un signal logique dont l'état est fonction du résultat de la comparaison,
- une bascule (13) connectée à la sortie du comparateur à seuil,
- des moyens de correction pour appliquer une correction de charge ou de décharge au condensateur (C), suivant l'état de la bascule (13), de manière à charger ou décharger le condensateur (C) et ramener sa tension vers la tension de seuil,
- un circuit de filtrage et de comptage (CN2) comprenant des moyens pour compter, à l'aide du signal image de l'état de la bascule (13), parmi les N dernières corrections appliquées au condensateur (C), le nombre de corrections de décharge auquel est retranché le nombre de corrections de charge, le nombre ainsi obtenu étant à tout instant représentatif du signal analogique reçu, et un circuit numérique apte à fournir ledit signal numérique, connecté à la borne de connexion (B), et comprenant un circuit numérique de mesure et de correction (CN1) et le circuit de filtrage et de comptage (CN2), le circuit numérique de mesure et de correction (CN1) comportant le comparateur (11) à seuil, la bascule (13), les moyens de correction, et des moyens pour prélever, pendant une phase de mesure périodique, la tension à la borne de connexion (B) et l'appliquer au comparateur à seuil (11) dont la sortie est stockée dans la bascule (13),
caractérisé en ce que le circuit analogique (CA) comprend:
- une première résistance (R1) au travers de laquelle le condensateur (C) se charge par le signal analogique reçu, et une seconde résistance (R2) par l'intermédiaire de laquelle le condensateur (C) est connecté à la borne de connexion (B), et en ce que le circuit numérique comprend:
- lesdits moyens de correction qui comprennent des moyens (12,14) pour appliquer à la borne de connexion (B), pendant une phase de correction périodique en alternance avec la phase de mesure, une tension de correction de charge ou de décharge du condensateur (C) dans la seconde résistance (R2).

2. Dispositif selon la revendication 1,
caractérisé en ce que la borne d'entrée (B) du circuit numérique est disposée de manière à réduire au maximum la longueur des liaisons entre les circuits analogique (CA) et numérique.

3. Dispositif selon l'une des revendications précédentes,
caractérisé en ce que le circuit de mesure et de correction (CN1) comprend une mémoire tampon (12) dont la sortie est reliée à la borne de connexion (B) avec le circuit analogique (CA), et une bascule D (13) dont l'entrée (d) est reliée à la sortie du comparateur numérique (11), dont la sortie inversée (nq) est reliée à l'entrée de la mémoire tampon (12), et dont la sortie non inversée (q) constitue la sortie (S1) du circuit de mesure et de correction, la bascule D (13) étant cadencée par un signal d'horloge (Ckm) synchrone du signal (En) de déblocage de la mémoire tampon (12).

4. Dispositif selon la revendication 3,
caractérisé en ce que le signal (En) de déblocage de la mémoire tampon (12) présente des flancs montants décalés d'un quart de période par rapport aux flancs montants du signal d'horloge (Ckm), et des flancs descendants en phase avec ceux du signal d'horloge (Ckm).

5. Dispositif selon l'une des revendications précédentes,
caractérisé en ce que le circuit de filtrage et de comptage (CN2) comprend un registre à décalage (21 à 24) initialisé à une valeur moyenne, et un compteur/décompteur (25) initialisé à ladite valeur moyenne, le registre à décalage étant chargé périodiquement avec les valeurs des tensions de correction appliquées au condensateur (C), le compteur/décompteur étant incrémenté si une valeur de tension de correction positive remplace une valeur de tension de correction nulle dans le registre à décalage (21 à 24), et décrémenté si une valeur de tension de correction nulle remplace une valeur de tension de correction positive dans le registre à décalage, de manière à ce que la valeur numérique du compteur/décompteur (25) reflète à tout instant, à une constante près, la valeur stockée dans le registre à décalage (21 à 24).

6. Dispositif selon la revendication 5,
caractérisé en ce que le nombre N de corrections sur lequel est réalisé le comptage correspond à la dimension du registre à décalage (21 à 24).

7. Dispositif selon la revendication 5 ou 6,
caractérisé én ce que le circuit de filtrage et de comptage (CN2) comprend une porte OU EXCLUSIF (26) dont une entrée est connectée à la sortie du registre à décalage (21 à 24) et dont la sortie est reliée à l'entrée de déclenchement d'un comptage du compteur/décompteur (25), les valeurs de tension de correction issues du circuit de mesure et de correction (CN1) étant appliquées à la fois à l'entrée du registre à décalage (21 à 24), à l'entrée du compteur/décompteur, et à l'entrée de la porte OU EXCLUSIF (26), le compteur/décompteur (25) délivrant des valeurs numériques représentatives de la moyenne du signal analogique appliqué en entrée (E) du circuit analogique (CA).

8. Dispositif selon l'une des revendications précédentes comprenant des moyens d'acquisition de deux signaux analogiques différentiels transmis respectivement par deux voies différentielles,
caractérisé en ce qu'il comprend:
- un circuit analogique (CA2) comportant deux voies sur lesquelles sont appliqués respectivement les deux signaux différentiels (IP, IM), chacune de ces deux voies comprenant un condensateur (C) qui est chargé par le signal analogique différentiel correspondant au travers d'une première résistance (R1), la tension aux bornes du condensateur (C) étant appliquée à une entrée (B) du circuit numérique au travers d'une seconde résistance (R2),
- deux circuits identiques audit circuit numérique connectés respectivement aux secondes résistances (R2) des deux voies du circuit analogique (CA2), chacun de ces circuits numériques délivrant à tout instant une valeur numérique représentative du signal analogique appliqué sur la voie correspondante du circuit analogique (CA2),
- des comparateurs numériques (37 à 40) aptes à détecter différents niveaux de tension, à l'aide des valeurs numériques représentatives des signaux analogiques différentiels (IP, IM) d'entrée, et
- un circuit logique (41) conçu pour engendrer deux signaux logiques (SH, SL) représentatifs des signaux analogiques (IP, IM) d'entrée, à partir des signaux issus desdits comparateurs numériques (37 à 41).

9. Dispositif selon la revendication 8,
caractérisé en ce qu'il comprend un seul circuit de filtrage et de comptage (CN2) connecté aux deux circuits de mesure et de correction (31,32) par l'intermédiaire d'un circuit d'interface (CN3) réalisant la fonction suivante :
- si les sorties des circuits de mesure et de correction (31,32) sont identiques à un instant donné, le circuit d'interface (CN3) applique au circuit de filtrage et de comptage (CN2) une valeur fixée arbitrairement à l'une des deux valeurs de tension de correction, puis alternativement à ces deux valeurs, et
- si les sorties des circuits de mesure et de correction (31,32) sont opposées, le circuit d'interface (CN3) applique au circuit de filtrage et de comptage (CN2) la valeur de tension de correction appliquée à l'une des deux voies différentielles (IP, IM).

10. Dispositif selon la revendication 8 ou 9,
caractérisé en ce que le circuit logique (41) émet un signal de recalage destiné à initialiser à ladite valeur moyenne, le registre à décalage (21 à 24) et le compteur/décompteur (25), lorsqu'il détecte que le signal d'entrée présente une tension voisine d'une tension de référence.

11. Dispositif selon l'une des revendications 8 à 10,
caractérisé en ce qu'il comprend une pluralité de chaînes d'acquisition de signaux différentiels, chaque chaîne recevant en entrée deux signaux analogiques différentiels, et délivrant en sortie deux signaux logiques (SH, SL) représentatifs des signaux analogiques (IP, IM) d'entrée, ledit dispositif comprenant en outre un seul générateur de phase apte à délivrer deux paires de signaux d'horloge (Ckm) et de déblocage (En) de la mémoire tampon (12) en opposition de phase, chacune de ces deux paires étant utilisée pour le cadencement d'une moitié respective desdites chaînes d'acquisition.

## Patentansprüche

1. Vorrichtung für die Umwandlung eines analogen Signals für die Übertragung von digitalen Daten in ein digitales Signal, mit:
- einem rein passiven Schaltkreis (CA), an den das empfangene analoge Signal angelegt wird, wobei dieser Schaltkreis einen Kondensator (C) beinhaltet, der von dem empfangenen analogen Signal aufgeladen wird, und eine Verbindungsklemme (B),
- einem Komparator (11) mit Schwellenwert, um die Spannung an den Anschlussklemmen des Kondensators (C) mit einem Schwellenwert zu vergleichen und ein analoges Signal abzugeben, dessen Zustand vom Ergebnis des Vergleichs abhängt,
- einem Flipflop (13), der an den Ausgang des Komparators mit Schwellenwert angeschlossen ist,
- Korrektureinrichtungen, um je nach dem Zustand des Flipflops (13) eine Lade- oder Entladekorrektur an den Kondensator (C) anzuwenden, um den Kondensator (C) zu laden oder zu entladen und seine Spannung auf den Spannungsschwellenwert zu bringen,
- einem Filter- und Zählschaltkreis (CN2), der Mittel enthält, um mithilfe des Bildsignals für den Zustand des Flipflops (13) unter den N letzten Korrekturen, die an den Kondensator (C) angelegt worden sind, die Zahl der Entladekorrekturen zu zählen, von denen die Zahl der Ladekorrekturen abgezogen wird, wobei die auf diese Weise erhaltene Zahl jederzeit für das empfangene analoge Signal repräsentativ ist, und
- einem digitalen Schaltkreis, der in der Lage ist, das genannte digitale Signal zu liefern, an die Verbindungsklemme (B) angeschlossen ist und einen digitalen Mess- und Korrekturschaltkreis (CN1) beinhaltet, sowie den Filter- und Zählschaltkreis (CN2), wobei der digitale Mess- und Korrekturschaltkreis (CN1) den Komparator mit Schwellenwert (11), den Flipflop (13), die Korrekturmittel und Mittel enthält, um während einer periodischen Messphase die Spannung an der Verbindungsklemme (B) abzunehmen und sie an den Komparator mit Schwellenwert (11) anzulegen, dessen Ausgang im Flipflop (13) gespeichert wird,
dadurch gekennzeichnet, dass der analoge Schaltkreis (CA) folgendes beinhaltet:
- einen ersten Widerstand (R1), über den sich der Kondensator (C) mit dem empfangenen analogen Signal auflädt, und einen zweiten Widerstand (R2), über den der Kondensator (C) an die Verbindungsklemme (B) angeschlossen ist,
und dadurch gekennzeichnet, dass der digitale Schaltkreis die genannten Korrekturmittel beinhaltet, zu denen die Mittel (12, 14) gehören, um an die Verbindungsklemme (B) während einer periodischen Korrekturphase, die mit der Messphase abwechselt, eine Korrekturspannung für das Laden oder Entladen des Kondensators (C) im zweiten Widerstand (R2) anzulegen.

2. Vorrichtung gemäß Patentanspruch 1,
dadurch gekennzeichnet, dass die Eingangsklemme (B) des digitalen Schaltkreises so angeordnet ist, dass die Länge der Verbindungen zwischen den analogen (CA) und digitalen Schaltkreisen auf ein Minimum verkürzt wird.

3. Vorrichtung gemäß einem der vorangegangenen Patentansprüche,
dadurch gekennzeichnet, dass der Mess- und Korrekturschaltkreis (CN1) einen Pufferspeicher (12) beinhaltet, dessen Ausgang mit dem analogen Schaltkreis (CA) an die Verbindungsklemme (B) angeschlossen ist, und einen Flipflop D (13), dessen Eingang (d) an den Ausgang des digitalen Komparators (11) angeschlossen ist, dessen umgekehrter Ausgang (nq) an den Eingang des Pufferspeichers (12) angeschlossen ist und dessen nicht umgekehrter Ausgang (q) den Ausgang (S1) des Mess- und Korrekturschaltkreises darstellt, wobei der Flipflop D (13) anhand eines Taktsignals (Ckm) getaktet ist, das mit dem Signal (En) für die Freigabe des Pufferspeichers (12) synchronisiert ist.

4. Vorrichtung gemäß Patentanspruch 3,
dadurch gekennzeichnet, dass das Signal (En) für die Freigabe des Pufferspeichers (12) aufsteigende Flanken aufweist, die um eine Viertelperiode im Verhältnis zu den aufsteigenden Flanken des Taktsignals (Ckm) verschoben sind und die absteigenden Flanken mit denen des Taktsignals (Ckm) phasengleich sind.

5. Vorrichtung gemäß einem der vorangegangenen Patentansprüche,
dadurch gekennzeichnet, dass der Filter- und Zählschaltkreis (CN2) ein Register mit Versatz (21 bis 24) aufweist, das auf einen Mittelwert initialisiert wird, und einen Zähler/Abwärtszähler (25), der auf den genannten Mittelwert initialisiert wird, wobei das Register mit Versatz periodisch mit den Werten der Korrekturspannungen geladen wird, die auf den Kondensator (C) angewendet worden sind, wobei der Zähler/Abwärtszähler inkrementiert wird, wenn ein positiver Korrekturspannungswert einen Null-Korrekturspannungswert im Register mit Versatz (21 bis 24) ersetzt, und dekrementiert wird, wenn ein Null-Korrekturspannungswert einen positiven Korrekturspannungswert im Register mit Versatz ersetzt, so dass der digitale Wert des Zählers/Abwärtszählers (25) jederzeit auf eine Konstante genau den Wert wiederspiegelt, der im Register mit Versatz (21 bis 24) gespeichert ist.

6. Vorrichtung gemäß Patentanspruch 5,
dadurch gekennzeichnet, dass die Anzahl N der Korrekturen, anhand welcher die Zählung erfolgt, der Größe des Registers mit Versatz (21 bis 24) entspricht.

7. Vorrichtung gemäß Patentanspruch 5 oder 6,
dadurch gekennzeichnet, dass der Filter- und Zählschaltkreis (CN2) eine Exklusiv-ODER-Schaltung (26) beinhaltet, deren einer Eingang an den Ausgang des Registers mit Versatz (21 bis 24) angeschlossen ist und deren Ausgang an den Eingang für das Auslösen einer Zählung des Zählers/Abwärtszählers (25) angeschlossen ist, wobei die Werte der Korrekturspannung, die aus dem Mess- und Korrekturschaltkreis (CN1) hervorgegangen sind, gleichzeitig an den Eingang des Registers mit Versatz (21 bis 24), an den Eingang des Zählers/Abwärtszählers und an den Eingang der Exklusiv-ODER-Schaltung (26) angelegt werden, wobei der Zähler/Abwärtszähler (25) digitale Werte liefert, die dem Mittelwert des analogen Signals entsprechen, das an den Eingang (E) des analogen Schaltkreises (CA) angelegt worden ist.

8. Vorrichtung gemäß einem der vorangegangenen Patentansprüche,
mit Mitteln für die Erfassung von zwei differentialen analogen Signalen, die jeweils über zwei differentiale Kanäle übertragen werden,
dadurch gekennzeichnet, dass sie folgendes beinhaltet:
- einen analogen Schaltkreis (CA) mit zwei Kanälen, an die jeweils die beiden differentialen Signale (IP, IM) angelegt werden, wobei jeder dieser beiden Kanäle einen Kondensator (C) beinhaltet, der über einen ersten Widerstand (R1) mit dem entsprechenden differentialen analogen Signal aufgeladen wird, wobei die Spannung an den Anschlüssen des Kondensators (C) über einen zweiten Widerstand (R2) an einen Eingang (B) des digitalen Schaltkreises angelegt wird,
- zwei Schaltkreise, die mit dem genannten digitalen Schaltkreis identisch sind und die jeweils an die zweiten Widerstände (R2) der beiden Kanäle des analogen Schaltkreises (CA2) angeschlossen sind, wobei jeder dieser digitalen Schaltkreise jederzeit einen digitalen Wert liefert, der dem analogen Signal entspricht, das an den entsprechenden analogen Kanal des analogen Schaltkreises (CA2) angelegt wird,
- digitale Komparatoren (37 bis 40), die anhand der digitalen Werte, die den differentialen analogen Eingangssignalen (IP, IM) entsprechen, in der Lage sind, verschiedene Spannungspegel festzustellen, und
- einen logischen Schaltkreis (41), der so konzipiert ist, dass er anhand der Signale, die aus den genannten digitalen Komparatoren (37 bis 41) hervorgegangen sind, zwei logische Signale (SH, SL) erzeugt, die den analogen Eingangssignalen (IP, IM) entsprechen.

9. Vorrichtung gemäß Patentanspruch 8,
dadurch gekennzeichnet, dass sie einen einzigen Filter- und Zählschaltkreis (CN2) beinhaltet, der an zwei Mess- und Korrekturschaltkreise (31, 32) angeschlossen ist, und zwar anhand eines Schnittstellenschaltkreises (CN3), der folgende Funktionen gewährleistet:
- wenn die Ausgänge der Mess- und Korrekturschaltkreise (31, 32) zu einem bestimmten Zeitpunkt identisch sind, legt der Schnittstellenschaltkreis (CN2) an den Filter- und Zählschaltkreis (CN2) einen Wert an, der willkürlich auf einen der beiden Werte der Korrekturspannung und sodann abwechselnd auf diese beiden Werte festgelegt wird und
- wenn die Ausgänge der Mess- und Korrekturschaltkreise (31, 32) entgegengesetzt sind, legt der Schnittstellenschaltkreis (CN3) an den Filter- und Zählschaltkreis (CN2) den Wert der Korrekturspannung an, der auf einen der beiden differentialen Kanäle (IP, IM) anwendet worden ist.

10. Vorrichtung gemäß Patentanspruch 8 oder 9,
dadurch gekennzeichnet, dass der logische Schaltkreis (41) ein Korrektursignal sendet, das dazu bestimmt ist, um das Register mit Versatz (21 bis 24) und den Zähler/Abwärtszähler (25) auf den genannten Mittelwert zu initialisieren, wenn er feststellt, dass das Eingangssignal eine Spannung aufweist, die in der Nähe einer Referenzspannung liegt.

11. Vorrichtung gemäß einem der Patentansprüche 8 bis 10,
dadurch gekennzeichnet, dass sie eine Mehrzahl von Ketten für die Erfassung von differentialen Signalen beinhaltet, wobei jede Kette am Eingang zwei differentiale analoge Signale empfängt und am Ausgang zwei logische Signale (SH, SL) abgibt, die für die analogen Eingangssignale (IP, IM) stehen, wobei die genannte Vorrichtung darüber hinaus einen einzigen Phasengenerator beinhaltet, der in der Lage ist, zwei Paare von Taktsignalen (Ckm) und Signalen für die Freigabe (En) des Pufferspeichers (12) in Phasenopposition abzugeben, wobei jedes dieser beiden Paare für die Taktung einer jeweiligen Hälfte der Erfassungsketten verwendet wird.

## Claims

1. Device for converting a numerical data transmission analog signal into a numerical signal including :
- a purely passive analog circuit (CA) to which the analog signal received is applied, this circuit including a capacitor (C) which is charged by the received analog signal, and a connection terminal (B),
- a threshold comparator (11) for comparing with a threshold the voltage at the terminals of the capacitor (C) and delivering a logic signal whose state depends on the result of the comparison,
- a sweep circuit (13) connected to the output of the threshold comparator,
- correction means to apply a charge or discharge correction to the capacitor (C) according to the state of the sweep circuit (13) so as to charge or discharge the capacitor (C) and bring its voltage back to the threshold voltage,
- a counting and filtering circuit (CN2) including means for counting with the aid of the image signal of the state of the sweep circuit (13) from the N latest corrections applied to the capacitor (C) the number of discharge corrections from which subtracted is the number of charge corrections, the number finally obtained being at any moment representative of the received analog signal, and
- a numerical circuit for providing said numerical signal and connected to the connection terminal (B) and including a numerical correction and measuring circuit (CN1) and the counting and filtering circuit (CN2), the correction and measuring circuit (CN1) comprising the threshold comparator (11), the sweep circuit (13), the correction means and means to sample during a periodic measuring phase the voltage at the connection terminal (B) and apply it to the thresholds comparator (11) whose output is stored in the sweep circuit (13),
characterised in that the analog circuit (CA) includes a first resistor (R1) through which the capacitor (C) is charged by the received analog signal, and a second resistor (R2) by means of which the capacitor (C) is connected to the connection terminal (B), and in that the numerical circuit includes said correction means which include means (12, 14) to apply to the connection terminal (B) during a periodic correction phase alternating with the measuring phase a charge or discharge correction voltage of the capacitor (C) in the second resistor (R2).

2. Device according to claim 1,
characterised in that the input terminal (B) of the numerical circuit is placed so as to reduce as much as possible the length of the links between the analog (CA) and numerical circuits.

3. Device according to claim 1 or 2,
characterised in that the correction and measuring circuit (CN1) includes a first buffer memory (12) whose output is connected to the connection terminal (B) with the analog circuit (CA), and a sweep circuit D (13) whose input (d) is connected to the output of the numerical comparator (11) whose inverted output (nq) is connected to the input of the buffer memory (12) and whose non-inverted output (q) constitutes the output (S1) of the correction and measuring circuit, the sweep circuit D (13) being measured by a synchronous clock signal (Ckm) of the signal (En) for unblocking the buffer memory (12).

4. Device according to claim 3,
characterised in that the signal (En) for unblocking the buffer memory (12) has ascending flanks shifted 90° out of phase with respect to the rising flanks of the clock signal (Ckm) and descending flanks in phase with those of the clock signal (Ckm).

5. Device according to one of the preceding claims,
characterised in that the counting and filtering circuit (CN2) includes a shift register (21 to 24) initialised to an average value, and a counting down/counting device (25) initialised to said average value, the shift register being periodically loaded with the correction voltage values applied to the capacitor (C), the counting down/counting device being incremented of a positive correction value replaces a nil correction voltage value in the shift register (21 to 24) and decremented if a nil correction voltage value replaces a positive correction voltage value in the shift register so that the numerical value of the counting down/counting device (25) reflects at any moment within one constant the value stored in the shift register (21 to 24).

6. Device according to claim 5,
characterised in that the number N of corrections on which counting is carried out corresponds to the dimension of the shift register (21 to 24).

7. Device according to claim 5 or 6,
characterised in that the counting and filtering circuit (CN2) includes an exclusive-OR gate (26) whose input is connected to the output of the shift register (21 to 24) and whose output is connected to the input for triggering counting of the counting down/counting device (25), the voltage correction values derived from the correction and measuring circuit (CN1) being applied to both the input of the shift register (21 to 24), the input of the counting down/counting device and the input of the EXCLUSIVE-OR gate (26), the counting down/counting device (25) delivering numerical values representative of the average of the analog signal applied at the input (E) of the analog circuit (CA).

8. Device according to one of the preceding claims and including means for acquiring two differential analog signals transmitted respectively by two differential channels,
characterised in that it includes :
- an analog circuit (CA) comprising two channels on which the two differential signals (IP, IM) are respectively applied, each of these two channels including a capacitor (C) which is charged by the corresponding differential analog signal via a first resistor (R1), the voltage at the terminals of the capacitor (C) being applied to an input (B) of the numerical circuit via a second resistor (R2),
- two circuits identical to said numerical circuit and respectively connected to the second resistors (R2) of the two channels of the analog circuit (CA2), each of these numerical circuits delivering at any moment a numerical value representative of the analog signal applied on the corresponding channel of the analog circuit (CA2),
- numerical comparators (37 to 40) for detecting various voltage levels with the aid of numerical values representative of the differential analog input signals (IP, IM), and
- a logic circuit (41) for generating two logic signals (SH, SL) representative of the analog input signals (IP, IM) from signals originating from said numerical comparators (37 to 41).

9. Device according to claim 8,
characterised in that it includes a single counting and filtering circuit (CN2) connected to the two correction and measuring circuits (31, 32) by means of an interface circuit (CN3) carrying out the following function :
- if the outputs of the correction and measuring circuits (31, 32) are identical at a given moment, the interface circuit (CN3) applies to the counting and filtering circuit (CN2) an arbitrarily fixed value to one of the two voltage correction values and then alternately to these two values, and
- if the outputs of the correction and measuring circuits (31, 32) are opposing, the interface circuit (CN3) applies to the counting and filtering circuit (CN2) the voltage correction value applied to one of the two differential channels (IP, IM).

10. Device according to claim 8 or 9,
characterised in that the logic circuit (41) transmits a retiming signal for initialising to said average value the shift register (21 to 24) and the counting down/counting device (25) when it detects that the input signal has a voltage close to a reference voltage.

11. Device according to one of claims 8 to 10,
characterised in that it includes a plurality of chains for acquiring differential signals, each chain receiving at its input two differential analog signals and delivering at its output two logic signals (SH, SL) representative of the analog input signals (IP, IM), said device further including a single phase generator for delivering two pairs of clock (Ckm) and unblocking (En) signals of the memory buffer (12) in phase opposition, each of the two pairs being used for measuring one respective half of said acquisition chains.
